Europäisches Patentamt

European Patent Office

Office européen des brevets

(19)

(11) Publication number: **0 226 651 B1**

(12) # EUROPEAN PATENT SPECIFICATION

(45) Date of publication of patent specification: **24.04.91**    (51) Int. Cl.⁵: **C03C 25/02**, C23C 16/54

(21) Application number: **85116246.1**

(22) Date of filing: **19.12.85**

(54) Apparatus for chemical vapor deposition of a coating on an optical fiber.

(43) Date of publication of application:
**01.07.87 Bulletin 87/27**

(45) Publication of the grant of the patent:
**24.04.91 Bulletin 91/17**

(84) Designated Contracting States:
**DE FR GB IT NL SE**

(56) References cited:
**EP-A- 0 163 457**
**EP-A- 0 166 649**
**DE-A- 1 954 480**

(73) Proprietor: **Hewlett-Packard Company**
**Mail Stop 20 B-O, 3000 Hanover Street**
**Palo Alto, California 94304(US)**

(72) Inventor: **Schantz, Christopher A.**
**650 Bair Island Road**
**Redwood City California 94302(US)**
Inventor: **Hiskes, Ronald**
**3484 Waverley Street**
**Palo Alto California 94306(US)**

(74) Representative: **KOHLER SCHMID + PART-NER, Patentanwälte**
**Ruppmannstrasse 27**
**W-7000 Stuttgart 80(DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

Rank Xerox (UK) Business Services

## Description

The invention relates to an apparatus for chemical vapor deposition (CVD) of a coating on an optical fiber according to the preamble of claim 1 and a coating process utilizing the apparatus as well as an optical fiber obtainable by this coating process. An apparatus of that kind is used for applying on-line a corrosion resistant hermetic coating on the fiber when the fiber is pulled.

An apparatus for chemical vapor deposition of a coating on an optical fiber, comprising:

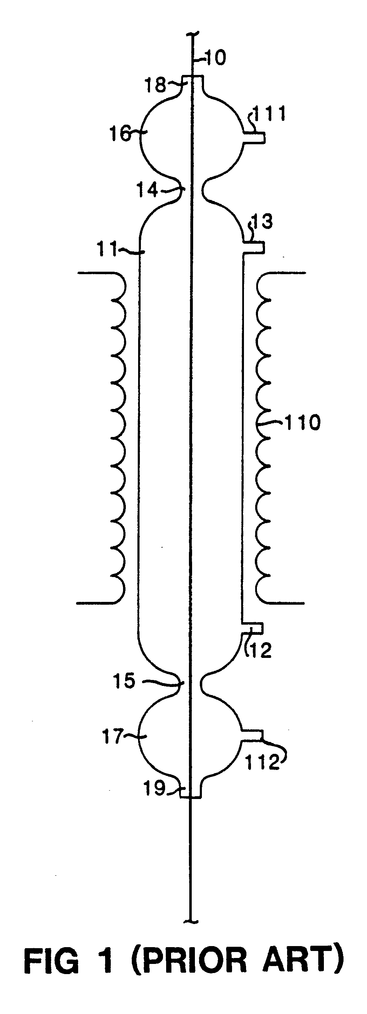

- a reaction chamber in which chemical vapor deposition is to take place, comprising a first fiber perture through which the fiber enters the chamber and a second fiber aperture through which the fiber leaves the chamber, and
- seals at each of the fiber apertures for sealing the reaction chamber from the environment, with the seal at the first fiber aperture being comprised of a gas according to the preamble of claim 1 is known from Japanese patent application 54-151 947 which was laid open in publication 55-75945. This known apparatus is shown in Fig. 1. It comprises a reaction chamber 11 that has a reactant inlet 12 and an exhaust port 13. The optical fiber 10 passes on-line through a fiber inlet 14 and a fiber outlet 15 of the reaction chamber. In order to prevent reactant gases from escaping through the fiberinlet or the fiber outlet, gas seals 16 and 17 respectively are located at the fiber inlet and at the fiber outlet. Seals 16 and 17 respectively have inlets 111 and 112 through which an inert gas is supplied and have apertures 18 and 19 through which the fiber is pulled. Gas seals are utilizes as the the seals at the fiber inlet and the fiberoutlet to avoid scratching and/or contaminating an optical fiber due to pasage through the seals.

The known apparatus has the disadvantage that ambient gases are entrained into the reaction chamber by the movement of the fiber. This problem arises primarily at aperture 18 in gas seal 16. When a fiber is pulled through the reaction chamber, a layer of ambient gases at the surface of the fiber is drawn through gas seal 16 into the reaction chamber. The problem becomes particularly troublesome at higher pulling speeds.

Accordingly it is the object of the invention to provide an apparatus for chemical vapor deposition of a coating on an optical fiber and process for coating on optical fiber by chemical vapor deposition utilizing the apparatus wherein the amount of ambient gases being drawn into the reaction chamber is substantially reduced.

The above object is solved in respect to the apparatus by the features characterized in claim 1. Accordingly an apparatus for chemical vapor deposition of a coating on an optical fiber, comprising:

- a reaction chamber in which chemical vapor deposition is to take place, comprising a first fiber aperture througgh which the fiber enters the chamber and a second fiber aperture through which the fiber leaves the chamber, and
- seals at each of the fiber apertures for sealing the reaction chamber from the environment, with the seal at the fist fiber aperture being comprised of a gas, which solves the above object is characterized in that the seal at the second fiber aperture is comprised of a liquid through which the optical fiber is pulled. The liquid seal prevents that air which may be drawn into the reaction chamber by the moving fiber through a fiber aperture can leave the chamber through the other fiber aperture. Thus, the internal pressure in the chamber increases, thereby pushing more air out of the chamber through the gas seal and tending to strip away the air that would otherwise be drawn into the chamber. With the use of a liquid seal, pulling speeds greater than 10 m/s can be implemented. Since the top seal is a gas seal, scratching of the fiber and chemical reaction with the freshly drawn fiber can be avoided. The bottom seal comprises a liquid which does not scratch or chemically attack the CVD coating.

According to claim 2, the liquid seal also serves for applying an additional coating on top of the coating which has been deposited by the CVD process. Claim 3 states a particular useful choice for such a liquid. According to claim 4, interaction of the reactant gases with the liquid of the seal can be avoided. According to claim 5, the apparatus can be oriented such that the weight of the fiber does not produce sag of the fiber.

According to a preferred embodiment of the apparatus and the process, the reactants supplied to the reaction chamber are selected to desposit a hermetic coating on the fiber. In one embodiment used to produce a fiber having an abrasion coating of silicone outside of the hermetic coating, liquid silicone is utilized as the liquid in the liquid seal. Clearly other coatings that are applied as a liquid could also be utilized in the liquid seal.

A small amount of an oxygen getter should be included in the reactant gases to bind the small amount of oxygen that is released by the optical fiber during the CVD coating process or that is drawn into the reaction chamber across the gas seal. A particularly useful choice of an oxygen getter is silane.

Subsequently, an embodiment of the invention is explained with reference to the drawings.

Figure 1 shows a cross-section of a prior CVD furnace utilizing a pair of gas seals.

Figure 2 shows a cross-section of a CVD furnace according to the invention utilizing one gas seal and one liquid seal.

Figures 3A-3C show the effect of fiber pulling speed and gas seal aperture diameter on the ambient gas entrained by a moving fiber.

In the Figures, the first digit of a reference numeral will indicate the first figure in which that element is shown. Analogous elements in different drawings will generally have reference numerals that differ only in the most significant digit.

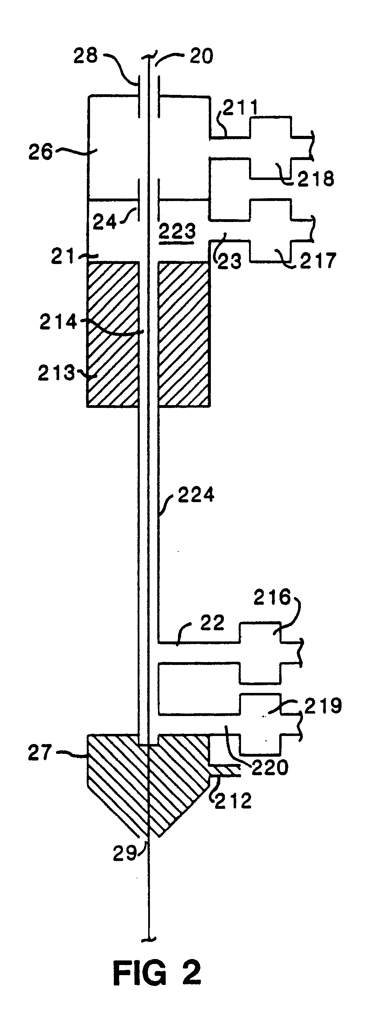

In Figure 2 is shown a cross-section of a chemical vapor deposition furnace according to the invention suitable for on-line deposition of a coating on a fiber 20 and in particular for depositing a coating on an optical fiber at high pull speeds. In the case of an optical fiber, the fiber is pulled on-line through the CVD furnace so that the fiber is protected by a deposited coating before it is wound onto a take-up reel. The furnace includes a reaction chamber 21, each end of which is terminated by one of a pair of seals 26 and 27. The reaction chamber has a reactant inlet 22 and an exhaust port 23. A set of fiber apertures 24, 28 and 29 in seals 26 and 27 enable the fiber to be pulled on-line through the reaction chamber for chemical vapor deposition of a coating.

The reaction chamber is oriented vertically with gas seal 26 at the top so that the weight of the fiber does not produce sag (as it would in a horizontal deposition process) that would tend to bring the fiber into contact with the walls defining apertures 24, 28, and 29. The top seal is a gas seal 26 having an inlet 211 for entrance of a relatively inert gas (e.g. $N_2$). The bottom seal is a liquid seal 27 having an inlet 212 for supply of a liquid into the seal. Most of the reaction chamber is filled with a vacuum bottle 213 that produces a cylindrical channel 214 about fiber 20. The diameter of the channel is on the order of 3 millimeters. The narrowness of the channel ensures that the reactant gas or gases pass through the reaction chamber in close proximity to the fiber so that they will effectively react with the fiber. In an alternative embodiment, in order to better preserve cylindrical symmetry of the system, each of the inlets and the exhaust port are connected to cylindrical gas transport channels that supply or exhaust gases from the furnace in a cylindrically symmetric manner. Also, to keep the reactant gases from interacting with the liquid in seal 27, inert gas is also supplied through an additional inert gas inlet 220 located just above the surface of the liquid in seal 27.

Seal 27 is selected to be a liquid seal so that entrained ambient gases are prevented from being drawn into reaction chamber 21 by the moving fiber. Mass flow controllers 216, 217, 218 and 219 control the flow of gases through inlet 22, exhaust port 23, inert gas inlet 220 and inlet 211, respectively. The amount of gas flowing from seal 26 through aperture 24 into the reaction chamber is equal to the difference between the flow through controller 217 and the sum of the flows through controllers 216 and 219. Similarly, the flow of gas through aperture 28 is the difference between the flow through controller 218 and through aperture 24. Therefore, the net average flow of gas through apertures 24 and 28 is determined by flow controllers 216-219. It should be noted that this is true independent of the fiber pulling speed. This contrasts with the system in Figure 1 in which the extra degree of freedom added by aperture 19 in the bottom gas seal prevents the flow through aperture 18 from being determined by control of the flow through exhaust port 13 and through inlets 12, 112 and 113.

Changes in velocity of the fiber produce brief changes in the flow rate through aperture 28, but such brief changes alter the pressure in the gas seal to reestablish the flow rates dictated by the flow controllers. Thus, the flow rate through aperture 28 is insensitive to the velocity of the fiber. This is important in establishing the ability to prevent the entrainment of ambient gases into the reaction chamber at pull speeds above 1 meter per second. In addition, it is important in producing uniform coats because the fiber pull speed typically varies by up to 30 % to maintain a constant fiber diameter in spite of variations in the preform. This improved blockage of entrained ambient gases enables the use of a larger aperture 28 (greater than 3 millimeters diameter) than aperture 18 (on the order of 0.3-1 millimeter diameter) in the two gas seal furnace of Figure 1.

When a buffer coating of silicone is desired outside the hermetic coating, the liquid in the bottom seal should be silicone. When this is the case, the fiber should be allowed to cool sufficiently that the resultant silicone coat is not adversely affected by temperature of the fiber. This requires that the fiber is cooled after passage through channel 214 in which the CVD reaction takes place. To achieve this cooling, an uninsulated portion 224 of the reaction chamber is included below insulation bottle 213. In a 1 meter per second process utilizing silicone as the liquid on the bottom seal, the length of the uninsulated portion 224 should be on the order of 0.75 meters.

Either hydrogen ($H_2$) or helium (He) diluent is supplied through inlet 220 at 0.6 liters per minute to dilute the reactant gas and to prevent the reactant gas from interacting with the liquid in seal 27.

$N_2$ is supplied through inlet 211 at 1 liter per minute and gases are exhausted through exhaust port 23 at 1.5 liters per minute so that a net flow of 0.7 liters per minute out through aperture 28 is achieved.

In CVD processes in which air can be allowed to reach the exhaust port, the gas seal 26 can be eliminated from the reaction chamber. In such a situation, region 223 near the exhaust port functions as a gas seal. The upward flow of gases in narrow channel 214 excludes this air from penetrating into channel 214. Therefore, channel 214 is a region in which the CVD reaction can take place without being affected by the entrained air. For example, in a process of depositing silicon nitride on an optical fiber, silane and ammonia reactants are supplied through reactant inlet 22. Because air is excluded from channel 214, silicon nitride is deposited in that region. In region 223, the oxygen in the air drawn into region 23 reacts with the silane to produce a powder that does not deposit on the fiber and is exhausted through exhaust port 23. As a result of this, the oxygen drawn into region 223 shuts down the CVD process in that region.

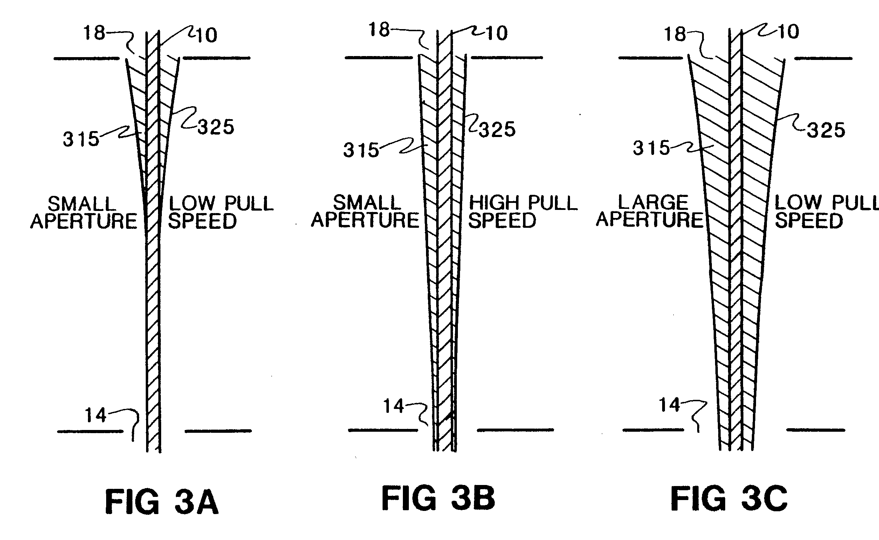

When gas seals are utilized at both ends of the reaction chamber as in the prior art according to Figure 1, it is very difficult to prevent the ambient atmosphere from being drawn by the moving fiber into the reaction chamber. Even with flow controllers controlling the flow of gas across inlets 12, 111 and 112 and across exhaust port 13, an increase in gas flow into reaction chamber 14 caused by entrainment of ambient gases across aperture 18 is compensated for by an increase in gas flow across aperture 19. This tends to let part of the ambient gases entrained by the moving fiber be drawn across the entire air seal as illustrated by comparison of Figure 3B with Figure 3A. In Figure 3A - 3C lines 325 are the locus of points at which gas flow is zero and hatched region 315 represents gases moving downward with the fiber. The fiber in Figure 3B is pulled at a higher speed than the fiber in Figure 3A so that the entrained gases are carried farther in Figure 3B. Thus, an increase in fiber pull speed will increase the amount of gas carried by the fiber across aperture 18 and, for high pull speeds, will carry ambient gases into the reaction chamber. For many CVD processes in which the ambient gas is air, the amount of oxygen drawn into the reaction chamber by the moving fiber significantly degrades the coat deposited by the CVD reaction.

It would also seem that the rate of flow of inert gas into gas seal 16 through inlet 111 could be increased and/or the diameter of aperture 18 could be decreased sufficiently that the rate of flow of inert gas through aperture 18 produces a shear flow past the fiber sufficient to strip the entrained ambient gas layer from the fiber before the fiber enters the reaction chamber. However, in accordance with the Bernoulli equation, the relative motion between the fiber and the inert gas flowing through aperture 18 produces a force on the fiber that tries to draw the fiber toward the edge of the aperture. To prevent the fiber from being drawn to the edge of the aperture and scratched by the resultant contact with the wall of seal 16, tension must be applied to the fiber sufficient to produce a restoring force toward the center of aperture 18 greater than the force toward the edge of aperture 18. Unfortunately, an increase in tension on the fiber needed to offset an increase in the Bernoulli force increases the amount of surface defects in the fiber. Therefore, the entrained air cannot be stripped from the fiber simply by reducing the diameter of aperture 18 and/or increasing the flow rate of inert gas through inlet 111. To provide more room for fiber vibration without contact between the fiber and the perimeter of aperture 18, the aperture diameter can be increased. However, as shown in Figure 3C, this diameter increase also increases the amount of entrained gas and therefore counters the benefit of increasing the flow rate of inert gas through inlet 111.

In a CVD chamber utilizing two gas seals as in Figure 1, the increase in gas flow into reaction chamber 11 caused by entrained gas through aperture 18 is compensated for by an increase in gas flow across aperture 19 due to entrained gas. In contrast to this, when at least one of the two seals is a liquid seal, gas cannot be transported across that seal to compensate for a change in gas flow across the other seal. In a system having one gas seal and one liquid seal, a change in speed will briefly change the rate of flow of gas across the aperture of the gas seal, but with the flow of gas across the other entrances and exits from the system controlled by flow controllers, the brief change in gas flow rate will produce a presure change in the reaction chamber and in the gas seal sufficient to re-establish the previous rate of gas flow across the gas seal aperture. This pressure change counters the tendency of a more rapidly moving fiber to carry ambient gases across the gas seal.

## Claims

1. An apparatus for chemical vapor deposition of a coating on an optical fiber, comprising:
   - a reaction chamber (21) in which chemical vapor deposition is to take place, comprising a first fiber aperture (24) through which the fiber (20) enters the chamber and a second fiber aperture (29) through which the fiber leaves the chamber, and

- seals (26,27) at each of the fiber apertures (24, 29) for sealing the reaction chamber from the environment, with the seal (26) at the first fiber aperture being comprised of a gas , **characterized** in that the seal (27) at the second fiber aperture is comprised of a liquid through which the optical fiber (20) is pulled.

2. An apparatus as in claim 1, **characterized** in that the liquid seal (27) contains a liquid that is to be applied on top of the coating deposited on the optical fiber in the CVD reaction chamber (21) to form an additional coating on the fiber.

3. An apparatus as in claim 2, **characterized** in that the liquid seal (27) contains liquid silicone.

4. An apparatus as in any of the preceding claims, **characterized** in that an inlet port (220) adjacent to the liquid seal (27) is provided for supplying an inert gas to the reaction chamber to prevent reactant gases from interacting with the liquid in the liquid seal (27).

5. An apparatus as in any of the preceding claims , **characterized** in that the apparatus is arranged such that the fiber is pulled through the reaction chamber (21) in a vertical direction with the top seal being the gas seal (26) and the bottom seal being the liquid seal (27).

6. An apparatus as in any of the preceding claims, **characterized** in that the gas seal (26) is greater than 3 millimeters in diameter.

7. An apparatus as in any of the preceding claims, **characterized** in that an inlet port (22) is provided for supplying reactant gases to and an exhaust port (23) for removing gases from the reaction chamber (21).

8. An apparatus as in any of the preceding claims,

**characterized** by a heat source for maintaining the reaction chamber at such a temperature that chemical reactions occur at the desired rate.

9. A process for coating an optical fiber by chemical vapor deposition utilizing an apparatus as in any of the preceding claims.

## Revendications

1. Un appareil pour le dépôt chimique en phase vapeur pour un revêtement sur une fibre optique comportant :
   - une chambre de réaction (21) dans laquelle le dépôt chimique en phase vapeur se produit, comprenant une première ouverture pour fibre (24) à travers laquelle la fibre (1) pénètre dans la chambre et une seconde ouverture pour fibre (29) à travers laquelle la fibre quitte la chambre, et
   - des joints d'étanchéité (26, 27) au niveau de chacune des ouvertures pour fibre (24, 29) pour rendre étanche la chambre de réaction par rapport à l'environnement, le joint d'étanchéité (26) au niveau de la première ouverture pour fibre étant constitué d'un gaz, caractérisé en ce que : le joint d'étanchéité (27) au niveau de la seconde ouverture pour fibre est constitué d'un liquide à travers lequel la fibre optique (20) est tirée.

2. Un appareil selon la revendication 1, caractérisé en ce que : le joint d'étanchéité liquide (27) renferme un liquide qui doit être-appliqué sur le revêtement déposé sur la fibre optique dans la chambre de réaction pour dépôt chimique en phase vapeur (21) afin de former un revêtement supplémentaire sur la fibre.

3. Un appareil selon la revendication 2, caractérisé en ce que : le joint d'étanchéité liquide (27) renferme un silicone liquide.

4. Un appareil selon l'une quelconque des revendications précédentes, caractérisé en ce que : on prévoit un orifice d'admission (220) adjacent au joint d'étanchéité liquide (27) pour introduire un gaz inerte dans la chambre de réaction afin d'éviter que des gaz réactifs n'interagissent avec le liquide dans le joint d'étanchéité liquide (27).

5. Un appareil selon l'une quelconque des revendications précédentes,
caractérisé en ce que :
l'appareil est agencé de façon telle que la fibre est tirée à travers la chambre de réaction (21) selon une direction verticale, le joint d'étanchéité supérieur étant le joint gazeux (26) et le joint d'étanchéité inférieur étant le joint d'étanchéité liquide (27).

6. Un appareil selon l'une quelconque des revendications précédentes,
caractérisé en ce que :
le joint d'étanchéité gazeux (26) est supérieur à 3 mm de diamètre.

7. Un appareil selon l'une quelconque des revendications précédentes,
caractérisé en ce que :
on prévoit un orifice d'admission (22) pour introduire des gaz réactifs dans et un orifice d'évacuation (23) pour éliminer les gaz de la chambre de réaction (21).

8. Un appareil selon l'une quelconque des revendications précédentes,
caractérisé par :
une source de chaleur pour maintenir la chambre de réaction à une température telle que les réactions chimiques se produisent à la vitesse désirée.

9. Un procédé pour revêtir une fibre optique par dépôt chimique en phase vapeur en mettant en oeuvre un appareil selon l'une des revendications précédentes.

## Ansprüche

1. Vorrichtung zur chemischen Dampfphasenabscheidung einer Beschichtung auf einer Lichtleitfaser mit:
   - einer Reaktionskammer (21), in der die chemische Dampfphasenabscheidung stattfindet und die eine erste Faseröffnung (24), durch die die Faser (20) in die Kammer eintritt, und eine zweite Faseröffnung (29), durch die die Faser die Kammer verläßt, aufweist, und
   - Dichtungen (26, 27) an jeder Faseröffnung (24, 29), um die Reaktionskammer nach außen abzudichten, wobei die Dichtung (26) der ersten Faseröffnung aus einem Gas besteht, dadurch gekennzeichnet, daß

die Dichtung (27) an der zweiten Faseröffnung aus einer Flüssigkeit besteht, durch die die Lichtleitfaser (20) gezogen wird.

2. Vorrichtung nach Anspruch 1,
dadurch gekennzeichnet, daß
die Flüssigkeitsdichtung (27) eine Flüssigkeit enthält, die außen auf die auf der Lichtleitfaser in der Dampfphasenabscheidungs-Reaktionskammer (21) abgeschiedene Beschichtung zur Bildung einer zusätzlichen Beschichtung auf der Faser aufzubringen ist.

3. Vorrichtung nach Anspruch 2,
dadurch gekennzeichnet, daß
die Flüssigkeitsdichtung (27) flüssiges Silizium enthält.

4. Vorrichtung nach einem der vorangehenden Ansprüche,
dadurch gekennzeichnet, daß
eine Einlaßöffnung (220) neben der Flüssigkeitsdichtung (27) vorgesehen ist, um der Reaktionskammer ein Inertgas zuzuführen, welches ein Einwirken reaktiver Gase auf die Flüssigkeit in der Flüssigkeitsdichtung (27) verhindert.

5. Vorrichtung nach einem der vorangehenden Ansprüche,
dadurch gekennzeichnet, daß
die Vorrichtung so angeordnet ist, daß die Faser durch die Reaktionskammer (21) in vertikaler Richtung gezogen wird, wobei die Gasdichtung (26) die obere Dichtung und die Flüssigkeitsdichtung (27) die Bodendichtung ist.

6. Vorrichtung nach einem der vorangehenden Ansprüche,
dadurch gekennzeichnet, daß
der Durchmesser der Gasdichtung (26) größer als 3 mm ist.

7. Vorrichtung nach einem der vorangehenden Ansprüche,
dadurch gekennzeichnet, daß
eine Einlaßöffnung (22) für die Zufuhr reaktiver Gase zur Reaktionskammer und eine Auslaßöffnung (23) für die Abfuhr von Gasen aus der Reaktionskammer (21) vorgesehen sind.

8. Vorrichtung nach einem der vorangehenden Ansprüche,
gekennzeichnet durch
eine Wärmequelle, welche eine solche Temperatur in der Reaktionskammer einstellt, daß chemische Reaktionen mit einer gewünschten Geschwindigkeit ablaufen.

9. Verfahren zur Beschichtung einer Lichtleitfaser mittels chemischer Dampfphasenabscheidung unter Verwendung einer Vorrichtung nach einem der vorangehenden Ansprüche.

FIG 1 (PRIOR ART)

**FIG 2**

EP 0 226 651 B1

18 10

315 325

SMALL
APERTURE

LOW PULL
SPEED

14

**FIG 3A**

18 10

315 325

SMALL
APERTURE

HIGH PULL
SPEED

14

**FIG 3B**

18 10

315 325

LARGE
APERTURE

LOW PULL
SPEED

14

**FIG 3C**